# EUROPEAN PATENT APPLICATION

(11) **EP 4 597 350 A1**
(43) Date of publication of application: **06.08.2025**
(21) Application number: 24154790.0
(22) Date of filing: 30.01.2024
(51) Int. Cl.: G06F 30/27, G05B 17/02

(54) **METHOD FOR GENERATING A SYNTHETIC DATASET**

(71) Applicant: Hitachi Energy Ltd, 8050 Zürich (CH)
(72) Inventor: SOTO, Mauricio, Knightdale, 27545 (US)
(74) Representative: Vossius & Partner Patentanwälte Rechtsanwälte mbB

(57) **Abstract**

The present disclosure relates to a method for generating a synthetic dataset of a power equipment. The method comprises 1a. obtaining a dataset of the power equipment having a plurality of data points, 1b. generating an initial synthetic value for at least one data point in the dataset obtained in 1a, 1c. determining whetherthe initial synthetic value satisfies at least one predetermined constraint, 1d. determining that the initial synthetic value is a final synthetic value when it is determined that the initial synthetic value satisfies the at least one predetermined constraint, or 1e. discarding the initial synthetic value and generating a new synthetic value when it is determined that the initial synthetic value does not satisfy the at least one predetermined constraint. Steps 1c. to 1e. are repeated using the new synthetic value generated in step 1e. until the new synthetic value satisfies the at least one predetermined constraint and is determined to be a final synthetic value. The method further comprises step 1f. performing steps 1b. to 1e. for all subsequent data points of the dataset, and step 1g. outputting a generated synthetic dataset comprising the final synthetic values.

## Description

The present disclosure relates to a method for generating a synthetic dataset, in particular of a power equipment.

For power equipment monitoring, e.g., a transformer, it may be challenging to gather data due to privacy or competitiveness concerns. The lack of operational and historical data may hinder testing monitoring tools, creating new products that require power equipment data and creating machine learning models and overall analysing data to create algorithms for the analysis of power equipment behaviour and their corresponding issues with monitoring and condition assessment.

Several approaches to obtain data from customers including anonymising data delivery through blockchain or creating platforms for voluntary data submission in exchange for free data analysis have been presented but they have not yet been successful.

The present disclosure has been made in view of the above problems and proposes an approach to generate synthetic high-fidelity data for power equipment functionality based on a combination of real data, domain knowledge expertise, and statistical tools.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for generating a synthetic dataset of a power equipment. The method comprises 1a. obtaining a dataset of the power equipment having a plurality of data points, 1b. generating an initial synthetic value for at least one data point in the dataset obtained in 1a, 1c. determining whetherthe initial synthetic value satisfies at least one predetermined constraint, 1d. determining that the initial synthetic value is a final synthetic value when it is determined that the initial synthetic value satisfies the at least one predetermined constraint, or 1e. discarding the initial synthetic value and generating a new synthetic value when it is determined that the initial synthetic value does not satisfy the at least one predetermined constraint. Steps 1c. to 1e. are repeated using the new synthetic value generated in step 1e. until the new synthetic value satisfies the at least one predetermined constraint and is determined to be a final synthetic value.

The method further comprises 1f. performing steps 1b. to 1e. for all subsequent data points of the dataset, and 1g. outputting a generated synthetic dataset comprising the final synthetic values.

The present disclosure further relates to a method for generating a synthetic dataset of a power equipment. The method comprises 1a. obtaining a dataset of the power equipment having at least one data point, 1b. generating an initial synthetic value for the at least one data point in the dataset obtained in 1a, c. determining whether the initial synthetic value satisfies at least one predetermined constraint, 1d. determining that the initial synthetic value is a final synthetic value (acceptable synthetic value) when it is determined that the initial synthetic value satisfies the at least one predetermined constraint, or 1e. generating a new synthetic value when it is determined that the initial synthetic value does not satisfy the at least one predetermined constraint. 1f. determine, when all synthetic datapoints have been selected, if all synthetic datapoints satisfy all constraints. Steps 1c. to 1f. are repeated using new synthetic values generated in step 1e. until the new synthetic values satisfy all predetermined constraints and are determined to be final synthetic values, or 1g. until a predetermined time constraint is reached. The method further comprises 1h. outputting a synthetic dataset comprising the final synthetic values, if final values were found within the time constrain. If no final values were found before the time constraint was reached, there is no valid output.

Various embodiments may preferably implement the following features.

Preferably, each initial and new synthetic value is a value generated using an analysis of historical values, domain specific knowledge, or randomisation.

Preferably, each initial synthetic value is generated by multiplying the respective data point with a first multiplier.

Preferably, the first multiplier is equal to or larger than 0 and equal to or less than 1.

Preferably, each initial and new synthetic value is generated using a machine learning model, empirical or a stochastic methodology.

Preferably, the new synthetic value is multiplied with a second multiplier, wherein the second multiplier is equal to or greater than zero, and preferably wherein the first multiplier is different from the second multiplier.

Preferably, the method further comprises applying at least one filter on each initial and new synthetic value for determining inadequate values based on at least one property of the power equipment and domain knowledge.

Preferably, the method further comprises generating the new synthetic value based on the determination of inadequate values.

Preferably, inadequate indicates a value that is unlikely or impossible to happen in the real world, such as a negative value for gas levels, which are always zero or above.

Preferably, the at least one predetermined constraint is one of a maximum deviation of the initial or new synthetic value from the data point, a slope of a plurality of initial or new synthetic values, a sign, or a deviation from a previous initial or new synthetic value.

Preferably, for each constraint, a predetermined value is provided indicating a number of data points and/or initial or new synthetic values used for determining whether the initial or new synthetic value satisfies the predetermined constraint.

Preferably, step 1e. further comprises discarding a predetermined number of final synthetic values in addition to the initial synthetic value and generating a new synthetic value for each discarded synthetic value. Preferably, repeating steps 1c. to 1e. is performed for each of the generated new synthetic values.

Preferably, the method further comprises correcting one of the initial or new synthetic values and at least one previous initial or new synthetic value based on the determination whether the initial or new synthetic value satisfies the at least one predetermined constraint. Preferably, the correcting is performed prior to step 1e.

Preferably, the power equipment is an electrical component of a power grid, in particular a transformer, a battery, a tap-changer, and/or a switchgear.

Preferably, the data points relate to dissolved gas analysis data, load data, bushing data, cooling data, insulation data, tap-changer, or temperature data.

Preferably, the method further comprises outputting an error signal when in the repetition of steps 1c. to 1e. no final synthetic value is determined after expiry of a predetermined time interval.

The present disclosure further relates to a device and/or power equipment comprising at least one processor configured to perform the method as described above. Moreover, the present disclosure relates to a corresponding computer-readable storage medium. The computer-readable storage medium comprises instructions which, when executed by a processor, configure the processor to perform the method as recited above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.
Fig. 1 shows a flow chart of a method according to an embodiment of the present disclosure.
Fig. 2 shows a flow chart of a method according to an embodiment of the present disclosure.
Fig. 3 shows example graphs resulting from a method according to an embodiment of the present disclosure.

Substitute data, in the following also referred to as synthetic data or surrogate data, is defined as any production data applicable to a given situation that is not obtained by direct measurement [1]. Data generated by statistical tools based on real data thus falls into this category. Synthetic data is typically created to meet specific needs or to be bound by certain conditions where real data is difficult to be obtained.

Synthetic data is commonly found in applications of physical modelling, such as music synthesizers or flight simulators. Generated data is also used in particular settings where real data is protected and thus, using real data would compromise the confidentiality of such data. This includes, for example, customer data protected by GDPR in Europe or HIPAA laws in the United States, as well as many other data privacy laws in different parts of the globe. The intent of creating synthetic data is to approximate how real data would look like or behave without the need of obtaining or using real data. Synthetic data should maintain the structure of the original data by creating new data based on the original data.

In particular, the substitute/synthetic data is used for mimicking the behaviour of the power equipment without having to use real data.

Synthetic data can then be used as theoretical values or situations that could potentially occur in real life and thus the data can be analysed to cover these cases. It does this by increasing the number of samples for training machine learning (ML) algorithms, particularly in cases for which there aren't enough data samples to obtain good accuracy in classification problems or low root mean square (RMSE) in regression problems. This helps to prepare for unexpected situations and propose a solution for when these potential cases happen in the real world.

The process of generating substitute/synthetic data may be denominated data synthesis. A method of generating such synthetic data according to an embodiment will be presented below.

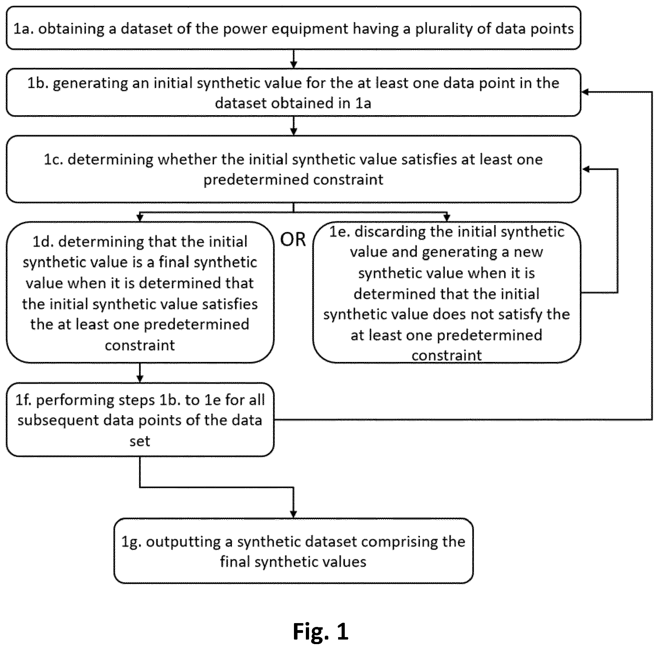

Fig. 1 shows a flow chart of a method according to an embodiment. The method comprises 1a. obtaining a dataset of the power equipment having a plurality of data points, 1b. generating an initial synthetic value for at least one data point in the dataset obtained in 1a, 1c. determining whether the initial synthetic value satisfies at least one predetermined constraint, 1d. determining that the initial synthetic value is a final synthetic value when it is determined that the initial synthetic value satisfies the at least one predetermined constraint, or 1e. discarding the initial synthetic value and generating a new synthetic value when it is determined that the initial synthetic value does not satisfy the at least one predetermined constraint. Steps 1c. to 1e. are repeated using the new synthetic value generated in step 1e. until the new synthetic value satisfies the at least one predetermined constraint and is determined to be a final synthetic value.

The method further comprises 1f. performing steps 1b. to 1e. for all subsequent data points of the dataset, and 1g. outputting a generated synthetic dataset comprising the final synthetic values.

That is, for each data point of the data set, steps 1b. to 1d. or steps 1b., 1c. and 1e. are performed, depending on whether the at least one predetermined constraint is satisfied (step 1f.). When all data points have been processed, the method terminates and outputs a synthetic dataset comprising the final synthetic values (step 1g.).

Alternatively, the method may output an error message and terminate in case no final synthetic value is found within a given time limit.

Since the term final synthetic value refers to a value that (at least preliminarily) satisfies the given constraint(s), it may also be referred to as acceptable synthetic value.

A method according to an embodiment of the present disclosure comprises the steps of 1a. obtaining a dataset of the power equipment having at least one data point, 1b. generating an initial synthetic value for the at least one data point in the dataset obtained in 1a, c. determining whether the initial synthetic value satisfies at least one predetermined constraint, 1d. determining that the initial synthetic value is a final synthetic value when it is determined that the initial synthetic value satisfies the at least one predetermined constraint, or 1e. generating a new synthetic value when it is determined that the initial synthetic value does not satisfy the at least one predetermined constraint. 1f. determine, when all synthetic datapoints have been selected, if all synthetic datapoints satisfy all constraints. Steps 1c. to 1f. are repeated using new synthetic values generated in step 1e. until the new synthetic values satisfy all predetermined constraints and are determined to be final synthetic values, or 1g. until a predetermined time constraint is reached. The method further comprises 1h. outputting a synthetic dataset comprising the final synthetic values, if final values were found within the time constrain. If no final values were found before the time constraint was reached, there is no valid output.

In the repetition, the new synthetic value replaces the initial synthetic value of step 1b. and the determination of step 1c. is accordingly performed using the new synthetic value.

In an embodiment, steps 1b. to 1e. may be repeated until a predetermined period of time (time interval) has elapsed. Also, an error signal may be output when in the repetition of steps 1b. to 1e. no final synthetic value is determined after expiry of a predetermined time interval.

Each initial and new synthetic value may be a value generated using an analysis of historical values, domain specific knowledge, or randomisation. Domain specific knowledge may refer to known behaviour of the power equipment, physical values, or parameters.

Each initial synthetic value may be generated by multiplying the respective data point with a first multiplier. The first multiplier may be equal to or larger than 0 and equal to or less than 1. The first multiplier may be predetermined.

Also, each initial and new synthetic value may be generated using a machine learning model, empirical or a stochastic methodology.

Further, the new synthetic value may be multiplied with a second multiplier. The second multiplier may be equal to or greater than zero. The first multiplier may be different from the second multiplier. The second multiplier may be predetermined.

In the generation of a synthetic data set, at least one filter may be applied on each initial and new synthetic value for determining inadequate values based on at least one property of the power equipment and domain knowledge. That is, the determination of inadequate values may be based on predetermined parameters.

Thus, the method may further comprise generating the new synthetic value based on the determination of inadequate values. I.e., if a synthetic value is determined to be inadequate ("impossible"), a new synthetic value may be generated.

As used herein, the term inadequate indicates a value that is unlikely or impossible to happen in the real world, such as a negative value for gas levels, which are always zero or above, or temperatures unlikely or impossible for a certain material or substance.

The at least one predetermined constraint may be one of a maximum deviation of the initial or new synthetic value from the data point, a slope of a plurality of initial or new synthetic values, a sign, or a deviation from a previous initial or new synthetic value. For each constraint, a predetermined value may be provided indicating a number of data points and/or initial or new synthetic values used for determining whether the initial or new synthetic value satisfies the predetermined constraint.

The method may further comprise correcting one of the initial or new synthetic values and at least one previous initial or new synthetic value based on the determination whether the initial or new synthetic value satisfies the at least one predetermined constraint.

The power equipment (asset) may be an electrical component of a power grid, in particular a transformer, a battery, a tap-changer, and/or a switchgear. The data points may relate to dissolved gas analysis data, load data, bushing data, cooling data, insulation data, tap-changer, or temperature data.

Thus, the present disclosure proposes creating a methodology that is able to generate synthetic time series data that behaves similarly to a given time series dataset. An important use case for this methodology may be to generate a dataset that can work as a surrogate of the initially given dataset. The method described above will be further elaborated on below.

The methodology proposed may take the following parameters as inputs: An initial time series dataset, a list of constraints and a list representing the number of datapoints the constraints are calculated from.

An initial time series dataset, i.e., the obtained dataset of the power equipment (original dataset), may be a time series that describes a dataset captured by a sensor in an asset (e.g., a transformer). A time series is a sequence of data points that occur in successive order over some period of time. For example, a dissolved gas analysis (DGA) sensor can read dissolved gas analysis readings periodically and log them, creating a time series of readings for each gas tracked.

The at least one constraint or a list of constraints (set of constraints) may comprise constraints indicating statuses for which both datasets (the initial dataset and the newly generated by the proposed method) need to match on. Examples of constraints in the example of DGA, may include: Duval pentagons diagnosis, IEEE status, IEC status, ETRA diagnosis, CO2/CO ratio, O2/N2 ratio, rogers ratio, etc. It may also include user generated constraints, such as that a surrogate value may never be 10ppm again from the original value, or that the slope of the last 10 datapoints of the surrogate data should not be more than twice the slope of the 10 datapoints of the original dataset.

In order to determine the matching, a list representing the number of datapoints the constraints are calculated from may be provided.

This list may be an integer per each constraint (see above) that describes how many datapoints are used to calculate each constraint. In the example of DGA, an O2/N2 ratio is calculated datapoint by datapoint. For each datapoint, this ratio is calculated using only the last datapoint, therefore the integer associated with this constraint would be "1" indicating that this constraint only needs one datapoint to be calculated.

Different from the slope of the last 10 datapoints, which uses the last 10 datapoints and therefore the integer associated with that constraint would be "10".

As outlined above, a time limit (predetermined time interval) may be defined. Said time limit may be a user-defined upper bound limit for which the method may execute and try to find a dataset for. If the time limit has passed and the method has not been able to find a surrogate dataset that satisfies all the constraints, it will stop execution and convey to the user that it was not able to find a solution.

In the following, an example of a pseudocode for executing the method according to an embodiment is presented.

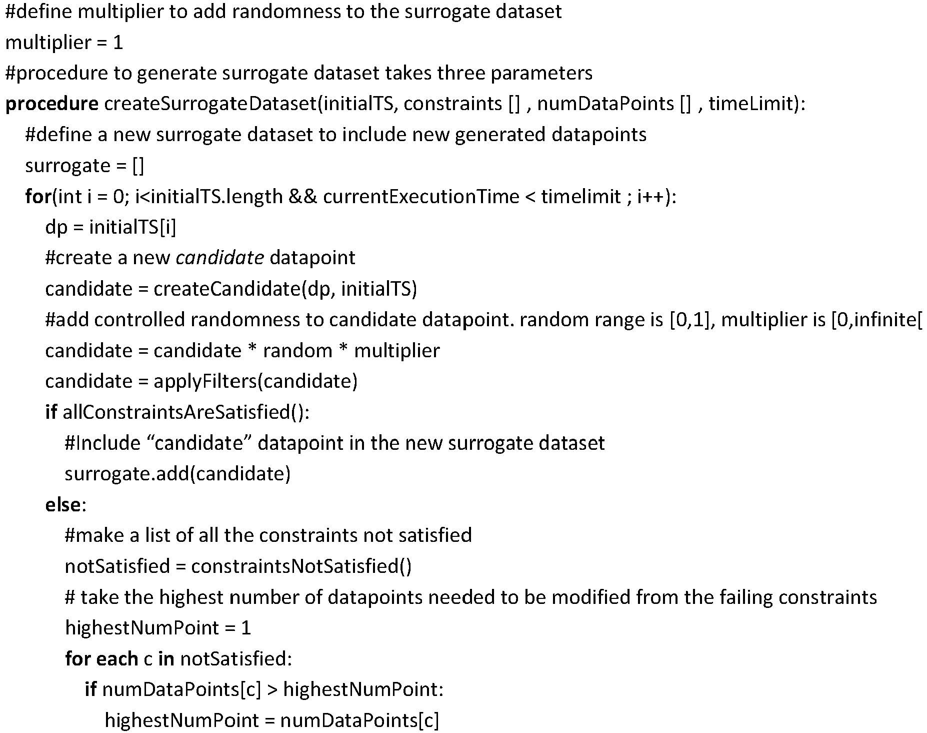

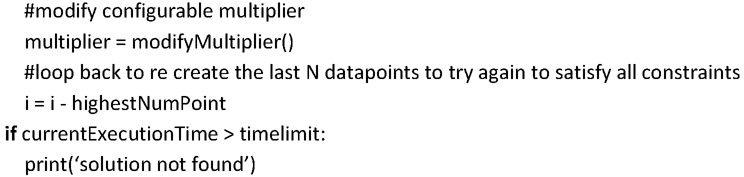

The basic idea of the algorithm is to go through each datapoint of the original time series, generating a surrogate time series that satisfies all the constraints given, as a definition of "behaving the same". When a constraint is not satisfied, the algorithm goes back and tries again to generate surrogate data that does satisfy all constraints, until either it is able to find a surrogate dataset that satisfies all constraints, or a user-defined time limit is reached.

As outlined above, the method may be performed with a (user specified) time limit, so that, if the method has not found a surrogate dataset that behaves the same as the original dataset based on the constraints provided, it will convey that a solution was not found. This may be due to the constraints being too narrow, or because the only possibility to satisfy all the constraints is by generating the exact same dataset as the original dataset, therefore not satisfying the purpose of the method which is the creation of surrogate data that is different from the original.

When successful, the proposed method ensures that both the surrogate dataset and the original dataset behave equally satisfying the given constraints.

The method as outlined above will be described with further details and examples in the following.

The methodology for generating a candidate datapoint (*createCandidate()* in the pseudocode provided above) can be using a machine learning model (e.g., a neural network that outputs the datapoint to be used in each step), an stochastic methodology (e.g., a random approach as the one described in [2] (to be published)).

The method for applying filters when the candidate datapoint is generated (*applyFilters()* in the pseudocode provided above) may use domain specific knowledge to make sure that the candidate datapoint complies with the behaviour of the sensor. That is, known behaviour of the asset/power equipment is used to rule out impossible or inadequate values. For example, DGA values cannot be negative values, temperature of the oil of a transformer cannot be in the millions of degrees, etc.

The method may also comprise a multiplication by a fixed multiplier (second multiplier) which provides more flexibility to the data generation process. This multiplier may be used to describe how close the generated dataset will be to the original dataset.

Different configurable multiplier values (second multiplier) may allow for more flexibility regarding how far from the original dataset the synthetic time series are. Overall, this methodology allows to generate high-fidelity synthetic time series data based on real time series readings in a flexible way. This method can also be repeated as many times as needed for more data. The method for modifying the multiplier (*modifyMultiplier()* in the pseudocode provided above) increases or decreases the second multiplier to increase or decrease randomness in the creation of the candidate datapoint, depending on what is needed to better try to satisfy the constraints.

When unsuccessful, the last N datapoints may be corrected to satisfy the constraints violated. This further enhances the possibility of adapting the synthetic time series to fulfil the given constraints.

In particular, the proposed method may allow for the correction of the last N datapoints to satisfy the constraints that require several datapoints to be calculated. In the cases where only the last datapoint is necessary to satisfy a violated constraint, the methodology will only modify the last datapoint. However, when violated constraints require several datapoints, the methodology will correct the last N datapoints required to calculate that constraint (see above list of constraints). Notice that "N" might be the entire time series (or a subset thereof) for constraints that can only be calculated given the entire time series, thus meaning that the algorithm may correct the entire dataset if one of these constraints is violated.

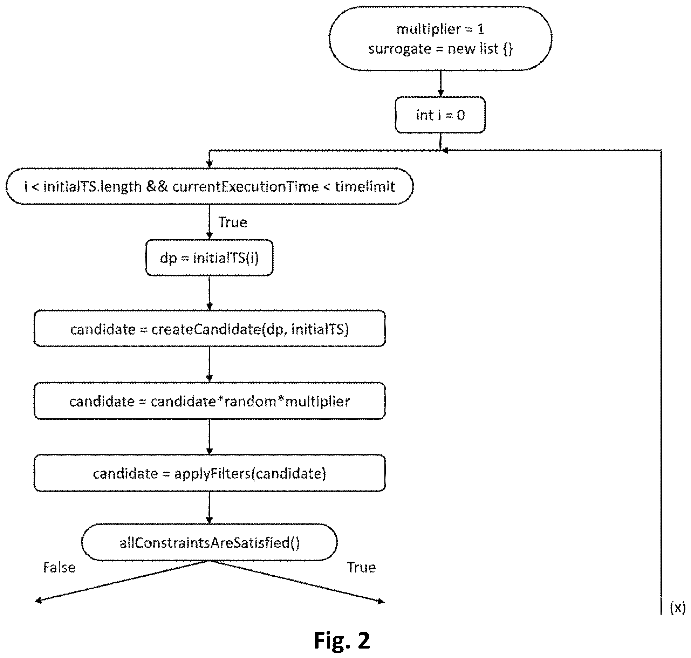

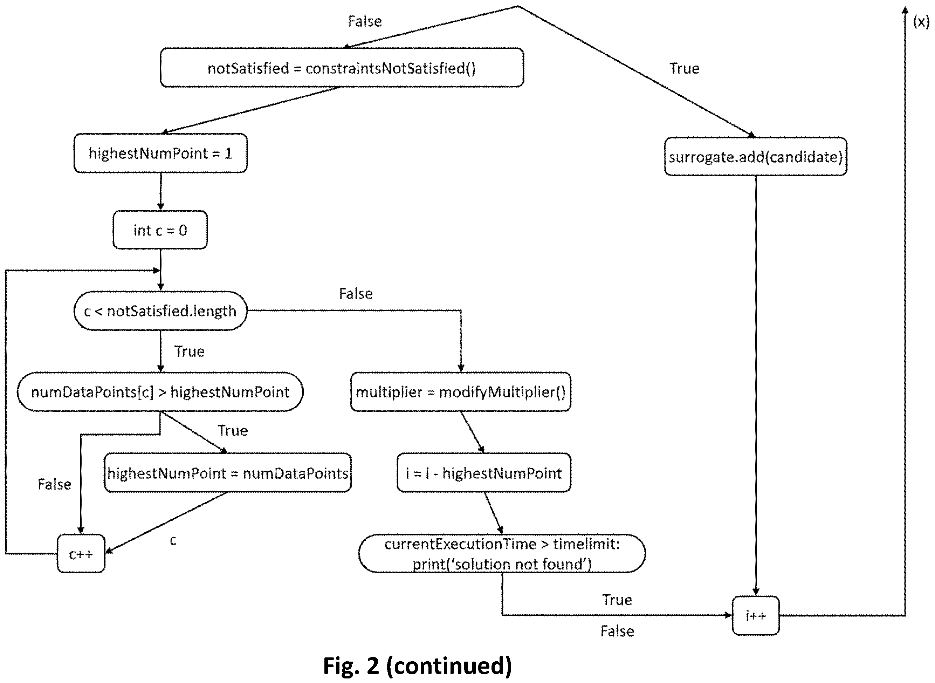

Fig. 2 is a further flow chart illustrating a method according to an embodiment of the present disclosure. The method is fully compatible with the one outlined above. The figure shows the method in a pseudocode manner and will be partially repeated in continuous text.

In the embodiment shown, the multiplier is set to 1. After the prompt to start generating a new list (*surrogate* = *new list {}*), the integer i is set to 0 (*int i* = 0).

As long as i is smaller than the length of the initial time series (TS) and the execution time is below a threshold (*i* < *initialTS.length && currentExecutionTime* < *timelimit*), a datapoint of the initial time series having index i will be processed (*dp = initialTS(i)*). Based on this datapoint, a function for creating a candidate (i.e., synthetic/surrogate/substitute value) is performed. The candidate is generated/altered by multiplying it with a random value and a multiplier which, in the present exmbodiment, has been set to 1 (*candidate = candidate*random*multiplier*)*.* Subsequently, a filter is applied to the newly generated candidate value (initial synthetic value).

If the newly generated candidate value (initial synthetic value) satisfies the constraints (*allConstraintsAreSatisfied() == True*), the initial synthetic value becomes a final synthetic value and is added to a list of synthetic/surrogate/substitute values (*surrogate.add(candidate)*)*.* Index i is incremented by 1 (i++), and the method is continued with the next datapoint or terminated in case all datapoints have been processed.

If the newly generated candidate value (initial synthetic value) does not satisfy the constraints (*allConstraintsAreSatisfied() == False*), the left branch of the flow chart (*notSatisfied = constraintsNotSatisfied()*) is performed. The variable *highestNumPoint* is set to 1 and the variable c is set to 0.

As long as c is smaller than the number of values not satisfying the constraints (c < *notSatisfied.length*), the values not satisfying the constraints are adapted as shown in the figure.

Otherwise, the multiplier is modified and i is set to *i* - *highestNumPoint.*

In case no solution is found within the time limit, an error message is output. In any case, i is incremented by 1 (*i++*) and the method is continued with the following data point.

In an embodiment, in case no synthetic value is found within the time limit, the method may either terminate or maintain, for isolated values, the original value as a synthetic value.

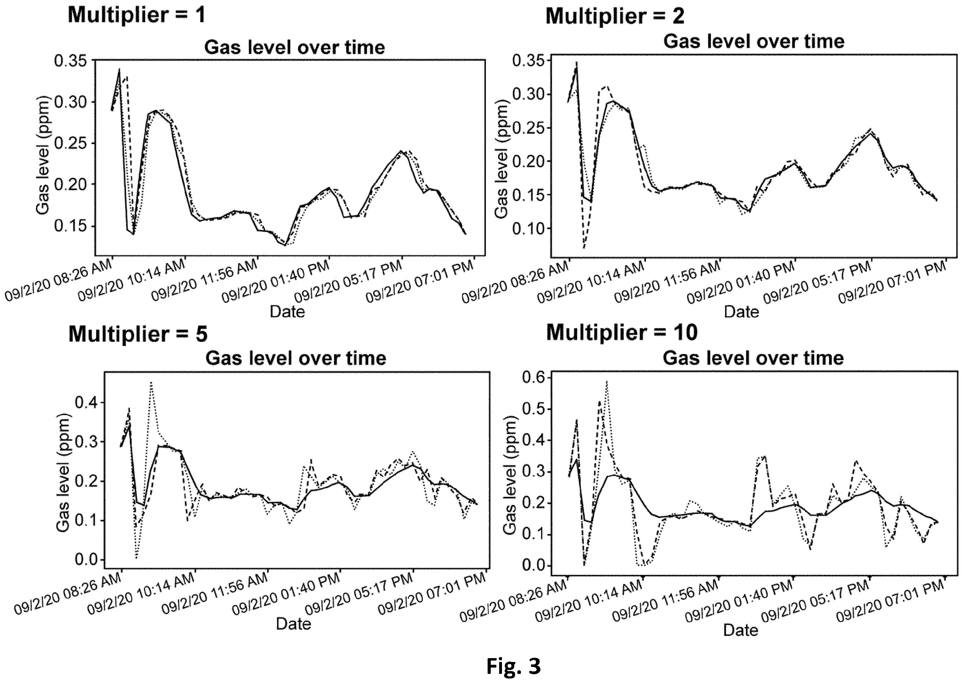

Fig. 3 shows example graphs resulting from a method as disclosed above. These example graphs show gas levels of the original dataset/time series (solid line) and two synthetic time series (dashed/dotted lines) over time for different (first) multipliers (Multiplier = 1, 2, 5, 10). As outlined above, the present disclosure is not limited to gas levels but may also be used for other power equipment parameters. As can be seen from the graphs, the synthetic time series differ from the original time series such that no conclusion to the original time series may be drawn. Moreover, the higher the multiplier, the larger the difference to the original time series.

The present disclosure further relates to a corresponding device connected to a power equipment comprising at least one processor. The processor is configured to perform the method as described above. The device may be, e.g., an Intelligent Electronic Device (IED).

Moreover, the present disclosure relates to a power equipment comprising at least one processor configured to perform the above method.

Further, the present disclosure encompasses a computer-readable storage medium storing instructions which, when executed by a processor, configure the processor to perform the method as outlined above.

According to an embodiment, the present data synthesis technique can be used in a system as described below. First, data is gathered from an asset/power equipment. In the following, a transformer will be taken as an example. This data may include dissolved gas analysis (DGA) data, load data, bushings, coolings, insulation, among others. Second, the system stores the data into a data base. This database can include data from transformers from the same substation, other substations and other companies. Third, the data is prepared to be feed to the synthetic data algorithm. This includes collecting and segregating the times series to be used for generation, defining the list of constraints and the datapoints needed per each constraint. Forth, the use case is defined. Synthetic data may be used for a number of use cases, including data anonymization, digital twin simulation, testing, data modeling, and machine learning training, testing and prediction, among others. Finally, the results of these use cases are used in the data analysis, design, and monitoring algorithms, in systems such as Electrical Design System (EDS), Common Design System (CDS), Spetra, TrafoStar, CoreTec, Asset Performance Management (APM), etc.

These components may operate independently of each other and asynchronous from each other. Thus, a transformer can gather data in a continuous form (on-line monitoring) and at a later time send that data to a data storage system. Thereafter, the data synthesis component can pull data from the storage system and generate synthetic data. Then one may pick a use case and create a solution based on that use case, and at a later time use it in proprietary tools. There can be any amount of time in between the actions of these components.

Also, these components can be replicated and work parallelly. For example: several transformers can be gathering online data at the same time. Similarly, the storage system can be distributed in several servers or data bases. Similarly, several data synthesis processing units can run parallelly to generate several synthetic streams from the same or different data storage locations. Regarding use cases, parallelly, some of the synthetic streams can be used for one use case while a parallel system is running the same component for the same or other use cases parallelly.

Based on the use case selected, in data analysis and monitoring algorithms of the system, extra information may be learned from the data, for example, digital twin simulation or machine learning training may use the data for learning additional information from the meta data, such as, how do the changes from one time series affect other time series, the correlation between data streams (variations between magnitude (x axis) and time (y axis)), how the transformer will behave under special circumstances (lightning, flood, earthquake, terrorist attack, physical damage of the transformer, when the transformer is de-energised or serviced, etc.) and prediction of values in each data stream.

One further aspect of the disclosure is the fact that, given its use of randomisation, it is extremely difficult to obtain the original time series based on the surrogated time series. This characteristic of this methodology makes it very useful for the purposes of data anonymisation. Similarly, data can be encrypted in the communication between each component to avoid data leakage.

In this disclosure, an approach to generate a power equipment data synthesizer capable of generating high-fidelity synthetic data for transformer functionality using a combination of real transformer data, domain knowledge expertise, and statistical tools has been presented. This methodology enables the generation of surrogate data so that (potentially sensitive) data may be shared without the concern of data leakage since it can be ensured that the generated surrogate data behaves the same as the (real) customer data but without the need for access to customer data. Some other uses cases where this technique may be applied to are for testing, simulation, digital twin solutions, and the creation of machine learning models that can predict harmful behaviour in the power equipment.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

### List of references

[1] Mullins, Craig S. (February 5, 2009). "What is Production Data?". NEON Enterprise Software, Inc. Archived from the original on 2009-07-21.
[2] (Under submission) Mauricio Soto, "Synthetic Data Generation and Its Applications: Training a Machine Learning Dissolved Gas Analysis Time Series Predictor", Cigre, 2024
[3] Weiss, M. "Modification of the Kolmogorov-Smirnov Statistic for Use with Correlated Data", Theory and Method, 1976, pp 872-875

## Claims

1. Method for generating a synthetic dataset of a power equipment, the method comprising:
1a. obtaining a dataset of the power equipment having a plurality of data points,
1b. generating an initial synthetic value for at least one data point in the dataset obtained in 1a,
1c. determining whetherthe initial synthetic value satisfies at least one predetermined constraint,
1d. determining that the initial synthetic value is a final synthetic value when it is determined that the initial synthetic value satisfies the at least one predetermined constraint, or
1e. discarding the initial synthetic value and generating a new synthetic value when it is determined that the initial synthetic value does not satisfy the at least one predetermined constraint,
wherein steps 1c. to 1e. are repeated using the new synthetic value generated in step 1e. until the new synthetic value satisfies the at least one predetermined constraint and is determined to be a final synthetic value,
1f. performing steps 1b. to 1e. for all subsequent data points of the dataset,
1g. outputting a generated synthetic dataset comprising the final synthetic values.

2. Method according to claim 1, wherein each initial and new synthetic value is a value generated using an analysis of historical values, domain specific knowledge, or randomisation.

3. Method according to claim 1 or 2, wherein each initial synthetic value is generated by multiplying the respective data point with a first multiplier,
wherein preferably, the first multiplier is equal to or larger than 0 and equal to or less than 1.

4. Method according to any one of claims 1 to 3, wherein each initial and new synthetic value is generated using a machine learning model, empirical or a stochastic methodology.

5. Method according to any one of claims 1 to 4, wherein the new synthetic value is multiplied with a second multiplier, wherein the second multiplier is equal to or greater than zero, and preferably wherein the first multiplier is different from the second multiplier.

6. Method according to any one of claims 1 to 5, wherein the method further comprises applying at least one filter on each initial and new synthetic value for determining inadequate values based on at least one property of the power equipment and domain knowledge,
wherein the method further comprises generating the new synthetic value based on the determination of inadequate values.

7. Method according to any one of claims 1 to 6, wherein the at least one predetermined constraint is one of a maximum deviation of the initial or new synthetic value from the data point, a slope of a plurality of initial or new synthetic values, a sign, or a deviation from a previous initial or new synthetic value.

8. Method according to any one of claims 1 to 7, wherein for each constraint, a predetermined value is provided indicating a number of data points and/or initial or new synthetic values used for determining whether the initial or new synthetic value satisfies the predetermined constraint.

9. Method according to any one of claims 1 to 8, wherein step 1e. further comprises discarding a predetermined number of final synthetic values in addition to the initial synthetic value and generating a new synthetic value for each discarded synthetic value and preferably wherein repeating steps 1c. to 1e. is performed for each of the generated new synthetic values.

10. Method according to any one of claims 1 to 9, wherein the power equipment is an electrical component of a power grid, in particular a transformer, a battery, a tap-changer, and/or a switchgear,
wherein the data points relate to dissolved gas analysis data, load data, bushing data, cooling data, insulation data, tap-changer, or temperature data.

11. Method according to any one of claims 1 to 10, wherein the method further comprises outputting an error signal when in the repetition of steps 1c. to 1e. no final synthetic value is determined after expiry of a predetermined time interval.

12. Device connected to a power equipment comprising at least one processor configured to perform the method according to any one of claims 1 to 11.

13. Power equipment comprising at least one processor configured to perform the method according to any one of claims 1 to 11.

14. Computer-readable storage medium comprising instructions which, when executed by a processor, configure the processor to perform the method according to any one of claims 1 to 11.
